# EUROPEAN PATENT SPECIFICATION

(11) **EP 1 184 982 B1**
(45) Date of publication and mention of the grant of the patent: **06.05.2009**
(21) Application number: 00118415.9
(22) Date of filing: 24.08.2000
(51) Int. Cl.: H03J 1/00, H04B 1/20, G06F 3/033

(54) **Remote control device**
Fernbedienungsgeber
Dispositif de télécommande

(43) Date of publication of application: 06.03.2002
(73) Proprietor: Sony Deutschland GmbH, 10785 Berlin (DE)
(72) Inventor: Michelitsch, Georg, Hedelfinger Strasse 61, 70327 Stuttgart (DE)
(74) Representative: Müller - Hoffmann & Partner

(56) References cited:
- US-A- 5 819 294
- US-A- 6 020 881

## Description

The present invention generally relates to a remote control which comprises a transmission means to transmit a command to a controllable device.

For home entertainment devices often a high number of different functions available via the remote control shall be provided. To facilitate the usage of the remote control, i. e. to enable the usage of a remote control without repeatedly studying an instruction manual, every manufacturer of a home entertainment device tries to design a corresponding remote control to be operated as intuitive as possible. Further, every home entertainment device manufacturer tries to provide a common look and feel to its remote controls comparable to that of the home entertainment devices. However, such a design leads to a high number of different remote controls for a user to control all available home entertainment devices.

To reduce the number of remote controls to be used within one home entertainment system it is known to use preprogrammed or programmable remote controls wherein predetermined commands to be output to control predetermined devices are assigned to a selected key of the preprogrammed or programmable remote control. However, such remote controls generally have the drawback that they are non-descriptive and a user easily gets confused, since a high number of functions is controllable from one device which generally has no corporate design or design specially adapted to a remotely controllable home entertainment device.

Therefore, it is the object underlying the present invention to provide a remote control which allows an intuitive operation of various home entertainment devices.

This object is solved with a remote control according to independent claim 1. Preferred embodiments thereof are respectively defined in the following dependent claims 2 to 9.

The remote control according to the present invention which comprises a transmission means to transmit a command to a controllable device is characterized by a receiving means for receiving a user interface of a controllable device upon selection of said controllable device with said remote control, and an adaptation means controlling an adaptation of said remote control to the received user interface.

Therefore, according to a user's point of view, the remote control according to the present invention adapts itself after selection of a particular controllable device. The receiving means might receive the user interface directly or via an appropriate transmission means from the controllable device itself or from a database storing user interfaces of available controllable devices. It is also possible that the remote control comprises such a database itself. Further, also a combination of these possibilities is possible. Regardless of the way how the user interface of the selected controllable device is received, after reception the remote control gets adapted to the received user interface by the adaptation means. Therefore, after selection of a controllable device the user can control said device via the remote control according to the present invention without having to remember special settings in respect to different controllable devices, since the remote control according to the present invention is adapted to only the received user interface.

Preferably, according to the present invention a controllable device is selected by pointing the remote control to said device and indicating to the remote control that said device to which the remote control points should be selected. Such an indication might be realized by depressing a predetermined button on the remote control or by keeping the remote control for a predetermined time in said position pointing to the controllable device to be selected.

Preferably, the remote control according to the present invention is characterized by a camera and an image processing unit to identify a device to which the remote control points. Alternatively or additionally, an infrared spot meter might be employed to identify a device to which the remote control points on basis of an infrared code transmitted by said device. Further preferably or alternatively, the remote control according to the present invention might comprise a scanner unit to identify a device to which the remote control points on basis of a bar code attached to said device.

These selected methods according to the present invention enable an intuitive usage of the remote control in that no complicated procedure has to be remembered how to adapt the remote control according to the present invention to an arbitrary device. In particular, it is possible that the user points to a controllable device and selects it, whereafter the remote control identifies the selected device to enable the receiving of the corresponding user interface. As indicated above, this receiving of the corresponding user interface can e. g. be enabled by sending an appropriate interface request command to the controllable device or by requesting the corresponding interface from a database, e. g. a database of a respective manufacturer which might be accessed from the remote control e.g via a home entertainment network and/or the internet.

The remote control according to the present invention is preferably characterized by a mechanical interface unit, a speech interface unit, a gesture interface unit and/or a graphics interface unit as user interface of the remote control to manipulate the received user interface of said selected device and thereby generating a command to be transmitted to said selected device.

Therewith, the remote control according to the present invention might be inherently multi-modal combining graphics, haptic, speech, and gesture.

Preferably, said mechanical interface unit comprises at least one soft key and/ or rotary dial. Further preferably, said at least one soft key and/or rotary dial is/are haptically enhanced.

Therewith, a very easy to understand remote control with an implicitly comprehensible user interface might be designed, since a switching through of different functions of the received user interface with the rotary dial and a selection and manipulation of a function with one or more soft keys is possible. Of course, also a switching through of different functions of the received user interface with one or more soft keys and a selection and manipulation of a function with the rotary dial is possible. Further, also a selection of one of different functions of the received user interface with a respectively assigned soft key and a selection and manipulation of the function with the rotary dial is possible. In particular, the combination of a mechanical interface unit with a graphics interface enables a visualization of a function selected by way of the rotary dial which function can currently be manipulated with the one or more soft keys.

The remote control according to the present invention preferably comprises a tilt sensor according to which output signal the manipulation of the received user interface is biased towards one of at least two interface units of the remote control and/or an appearance of an interface unit of the remote control is controlled.

This feature enables an advantageous switching between the several user interfaces of the remote control, e. g. in case the tilt sensor registers a movement of the remote control the gesture interface unit might be the primary input unit, whereas in case an upright position is detected the speech interface unit might be the primary interface, or in case a horizontally position is detected the graphics user interface serves as primary interface. Further, e. g. a content output from the remote control via the graphics interface unit might be controlled and/or in case the tilt sensor detects that the user cannot see a display of the graphics interface unit the remote control might give audio feedback via its speech interface instead of giving visual feedback.

The remote control according to the present invention preferably comprises a transfer means to transfer at least parts of a received user interface and/or at least one preset command associated to said user interface to another device.

In this case said other device might be an interface output device facilitating the control of the received device via the remote control for a user by outputting the transferred interface or parts thereof and/or displaying all preset commands. Therewith, the remote control according to the present invention cannot only use its own capabilities of giving a feedback to a user using the remote control for controlling another device, but can also use other devices, e. g. a television set for giving visual feedback and/or audio feedback.

Alternatively, said other device might be a further controllable device executing all transferred commands. In this case, preferably the transferring of commands is executed similar to the selection of a controlled device described above, i. e. by pointing to the further controllable device, so that a drag and drop semantics is achieved according to which preset commands might be issued to the further controllable device.

The remote control according to the present invention is preferably characterized in that said adaptation of the remote control is a projection of the received user interface onto a screen of the remote control and a fixed or variable assignment of projected controls to real controls of a user interface of the remote control.

In this case it is possible that e. g. the outer appearance of the user interface of a home entertainment device, e. g. the front panel of a home entertainment device with all its controls, is displayed on the screen of the remote control and individual controls of the front panel are "manipulated" via one or more soft keys and/or the rotary dial of the remote control as described above.

The remote control according to the present invention further preferably comprises a detachable base station including a recharge unit to recharge the remote control.

Therewith, according to the present invention a user can transfer the user interface from all kind of devices onto his/her remote control. Preferably, this operation can be thought of as a projection. From the remote control this projection might be projected again onto another device with display or other output capabilities such as a TV set. Using the remote control according to the present invention the user can manipulate the projected user interface with preferably haptically enhanced soft keys and a preferably similarly enhanced rotary dial. Further, the interaction method is inherently multi-modal combining graphics, haptic, speech and gesture. Furthermore, a tilt sensor might be embedded in the device to allow the remote control to bias its overall user interface e. g. towards speech when held upright and towards graphics when held horizontally and/or to control an appearance of an interface unit.

To select a device to be controlled the user can simply point to an arbitrary device and e. g. after holding a predetermined time in that direction or depressing a predetermined button the user interface from the selected device gets transferred to the remote control whereafter the remote control gets automatically adapted to control the selected device.

In addition, a drag and drop semantics is possible, for instance "show the user interface of the air-conditioning system on the TV set" in case the air-conditioning system is first selected by the user interface whereafter the received user interface of the air-conditioning system is projected onto the television, or "switch the audio channel of this telephone to the stereo system" in case a preset command of the user interface of the telephone which is first selected by the remote control according to the present invention indicates the mentioned command in case the remote control points to the stereo system after being adapted to the user interface of the telephone.

Further features and advantages of the remote control according to the present invention will become apparent from the following detailed description of an exemplary embodiment thereof taken in conjunction with the accompanying figures, wherein:
- **Figure 1**: shows two design scetchs of a preferred embodiment of the remote control according to the present invention;
- **Figure 2**: shows the remote control according to the preferred embodiment of the present invention with a base station/recharge unit; and
- **Figure 3**: shows a projection of a home entertainment device onto the remote control according to the preferred embodiment of the present invention and a TV set.

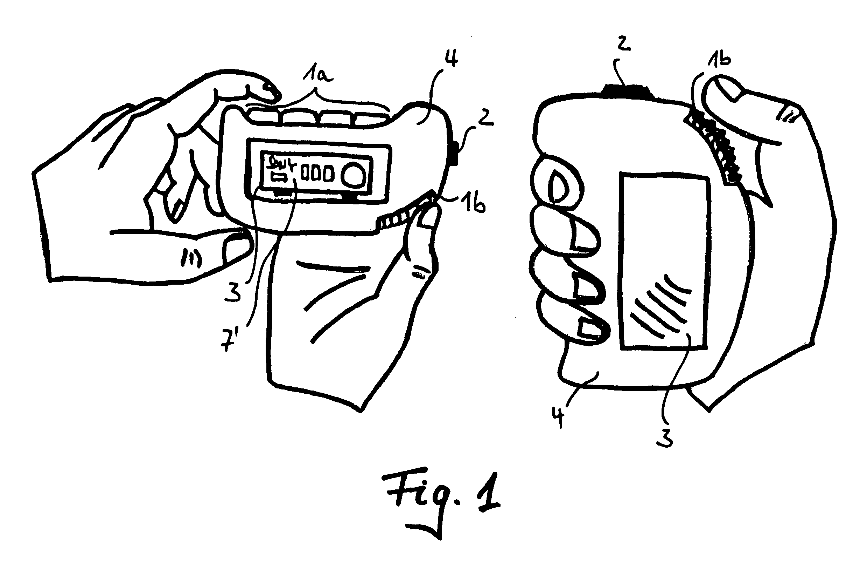

Figure 1 shows a preferred embodiment of the remote control according to the present invention in operation. The left hand side shows a two-handed interaction whereas the right hand side shows a one-handed interaction.

The remote control according to this preferred embodiment of the present invention comprises a shell having a basically ashlar form with a rotary dial or jog-dial 1b at one corner thereof, a microphone 2 at the short side panel adjacent to the jog-dial 1b, four soft keys 1a on the long side panel opposing the long side panel at which corner the jog-dial 1b is arranged and a display 3 arranged in the middle of a front panel.

In order to select a device with the remote control according to the present invention several combinable technologies are available or could be adapted for that purpose:
- Camera based in which case an image processing identifies the device to be controlled. This technology allows to select all kinds of controllable devices even if they do not know about the remote control. For example, the Cyber Code technology developped by the Applicant of the present invention is an example for such an approach.
- Infrared spot meter based where each device emits a unique infrared tune by which it can be recognized.
- Laser based wherein the remote control sends out a laser beam and reads a bar code like identifier attached to each device, i. e. similar to a scanner at a register in the supermarket.

Once a device is selected and the adaptation means controlled the projection of the corresponding user interface onto the screen of the remote control as well as the loading of the corresponding command set, the user can interact with the projection of the device comparable to the interaction with the real device.

The left hand side of Fig. 1 shows a typical example for a two-handed interaction wherein the user holds the remote control horizontally with the jog-dial 1b in the bottom right corner and the display 3 facing towards the user. It is then possible for the user to press one of the soft keys 1a with the fingers of the left hand and to rotate the jog-dial 1b with the thumb of his right hand. Each soft key is assigned to one functionality confined area of the device and the menu items show up on a carussel which turns in synchronism with the rotary dial.

Further to this mechanical/graphical interface gestures might be used for selecting devices and for transferring control between devices. In combination with a tilt sensor also the bias of the multi-modal user interface might be changed as described further below.

Additionally, speech input might center on commands and can be seen as a "trigger" in a multi-modal dialog, haptics might allow the control to adapt to the content and command structure of each device, graphical feedback might be given to the user whenever the actual content of entertainment title is audio-centric and the position sensor allows the remote control to know how it is held and adjust the user interaction model accordingly, e. g. by switching the display 3 which shows a projection 7' of a selected device 7 in the horizontal position, as shown on the left hand side of Fig. 1, to a blank screen when held in an upright position, as shown on the right hand side of Fig. 1, to indicate the user that instead of the visual interface now the speech interface of the remote control is primarily used.

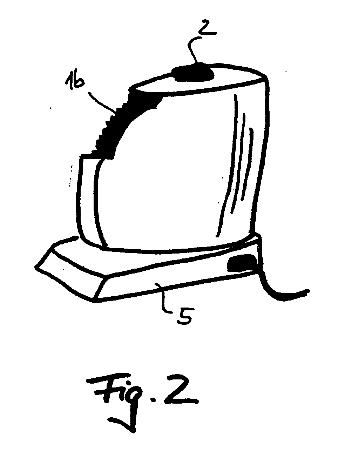

Fig. 2 shows the remote control according to the preferred embodiment of the present invention from its backside being attached to a base station/recharge unit 5 with its short side panel which is arranged opposite to the short side panel comprising the microphone 2. The base station/recharge unit 5 allows the recharging of (not shown) batteries within the remote control through (not shown) electric contacts within the side panel which is detached to the base station/recharge unit 5.

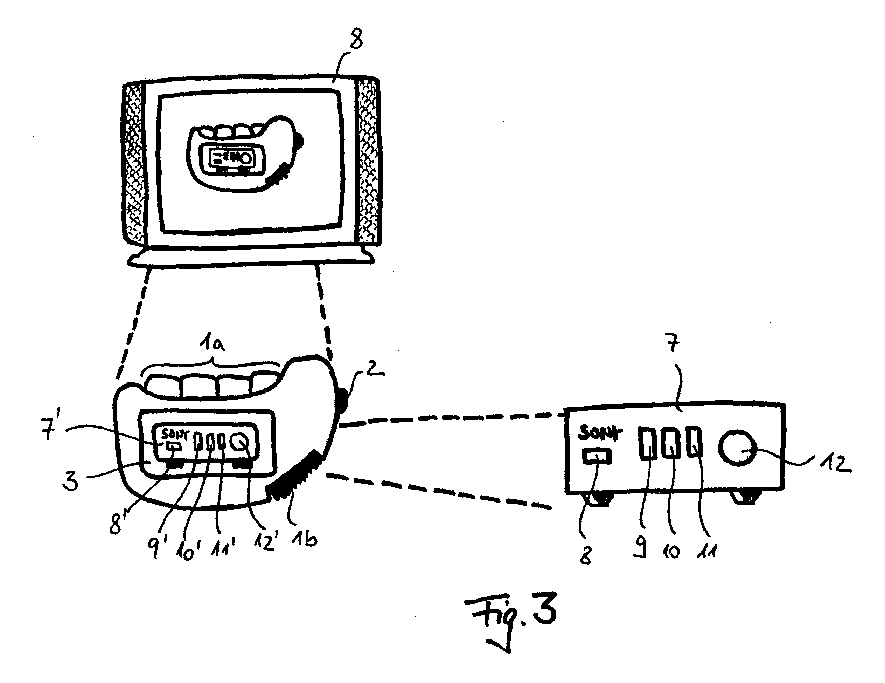

Fig. 3 shows the projection of a home entertainment device 7 onto the remote control according to the present invention and a further controllable device, in this case a TV set 8. After pointing the remote control according to the present invention to the controllable device 7, here an audio amplifier, the remote control requests and receives the user interface of the audio amplifier 7, adapts thereto and displays the user interface of the audio amplifier 7 on its display 3 as a virtual audio amplifier interface 7'. The audio amplifier 7 comprises as its user interface controls 8 to 12 on its front panel, i.e. a power button 8, three selection buttions 9 to 11, and a rotary dial 12. In this preferred embodiment of the present invention simply the front panel view of the audio amplifier 7 is displayed as virtual audio amplifier interface 7'. The audio amplifier can then be remotely manipulated, e. g. by selecting one of virtual controls 8' to 12' of the virtual audio amplifier interface 7'. Therefore, first one of the virtual controls 8' to 12' might be selected with the rotary dial 1b and thereafter a soft key 1a might be manipulated to "actuate" the selected control 8' to 12'. In case of the control 12' which does not only require a push button actuation as the controls 8' to 11', but rather a rotary actuation, the remote control according to the present invention might be adapted so that the soft key 1a used for actuation of a virtual push button control needs to be depressed in case of a virtual rotary control whereafter the rotary dial 1b can be used to manipulate the rotary control. This scheme can also be applied for a linear control. After release of the respective soft key 1a the rotary dial 1b might again be used to switch through the virtual controls 8' to 12' of the virtual audio amplifier command interface 7'. However, also other schemes to actuate the virtual controls 8' to 12' might be realized according to the present invention, e. g. the switching through of controls might be realized with one or two soft keys 1a instead of using the rotary dial 1b.

In any case this design of a remote control according to the present invention enables a rather small number of mechanical keys, i. e. soft keys 1a, rotary dial 1b and similar or equivalent means, to enable a user who is able to operate the real device to also operate it via the remote control according to the present invention. Therefore, the present invention enables an intuitive usage of a remote control for arbitrary devices.

Since it might be difficult in some cases to clearly show the virtual interface 7' on the display 3 of the remote control according to the present invention, or since this display 3 might have restricted capabilities in respect to resolution and/or colour, it is possible that the virtual interface 7' to which the remote control according to the present invention is adapted is therefrom projected onto an appropriate output device. It is also possible that not only the virtual interface 7', but the whole remote control gets projected onto the appropriate output device, like it is shown in Fig. 3, where the whole remote control including the virtual interface 7' of the audio amplifier is projected onto a television set 8. All capabilities of the television set 8 might be used to manipulate the projection of the controlled device, i. e. display and audio output. Further, it is also possible that the display is projected onto the television set 8 whereas the audio input and output might be projected onto a (not shown) head set which the user wears.

Each projection of a user interface to another device requires the adaptation to the capabilities of the target device. If for instance the remote control only offers grey scale graphics at a low resolution, then obviously the graphics used to represent the device to be controlled will be simpler than if a high resolution colour TV set is used. The projection on the TV 8 shows a virtual presentation of the remote control, which in turn carries the virtual repesentation 7' of the target device 7 that the user wants to control. This constitutes a recursive application of the projection paradigm.

As mentioned above, additionally to the position sensor according to which output signal the user interaction model of the remote control according to the present invention is adjusted, a tilt sensor might be provided for changing the bias in the multi-modal user interface. If the remote control is held horizontally so that the screen is seen in landscape formate, as it is shown on the left hand side of Fig. 1, then the graphical presentation might show the device to be controlled, e. g. the audio amplifier 7. On the other hand, if the remote control according to the present invention is held in such a way that the screen is seen in portrait formate, as it is shown on the right hand side of Fig. 1, then the graphics could be changed to a blank screen or e. g. to show the features of the device to be controlled in list form. However, if the user holds the remote control according to the present invention in such a way that the display cannot be seen, then the remote control changes the interaction strategy and gives audio feedback to the user instead of showing the feedback graphically.

As also mentioned above, the mechanical interface unit according to the present invention, i. e. the soft keys 1a and the rotary dial 1b, might be haptically enhanced. The haptification of the rotary dial 1b allows adapting the dial motion to items available for selection. The employed techniques might be:
- Artificial stops in dial motion wherein the dial stops at the end of a list based on the number of items that can be selected.
- Modulated transition between items wherein the transition between items in a list could be modeled to incorporate change in material (glass, rubber, etc) or change in the force to be overcome in order to get to the next item (ridges or different shape and size).
Further, the haptification of the soft keys 1a could be:
- Multi-stage buttons wherein the force feedback mechanism allows creating artificial barriers in the travel of the button, which are felt by the user at stages when pressing the button. The first stage can be used for showing an explanation of the function, the second stage then activates the function itself.
- Force feedback coordinated between all buttons for manipulating graphs which interaction modality allows changing of characteristics of a device that are best described in the form of a graph. The graph can be manipulated through control points, e. g. like in a B-spline. These control points are associated with the e. g. four soft keys on the the remote control. Through force feedback, the user can feel how the curve is transformed. The experience could be compared with forming clay with ones hand. Possible applications for this technique include tone control of audio equipment including equalizer settings, and adjusting the colout balance of the TV set. Of course, this technique of force feedback coordinated between all buttons for manipulating graphs is an advanced input/output technology which is not dependent on the remote control, but can be used for any applicable input/output scenario. The technique of force feedback coordinated between all soft keys for manipulating graphs is described in the applicants parallel european patent application "Method and Device to Manipulate a Data Set" which content is herewith incorporated into this specification by reference.

Another application of the haptification is the visualization of large data sets on the display 3. For example, data retrieved from an electronic programming guide (EPG) can be classified into genres such as comedy, action movies, soap operas and so on. By assigning one haptically enhanced soft key 1a to such a category, the user can convey his preferences to the system. Depressing a soft key 1b reduces the weighting of the associated category, which can be felt through increased resistance. The other categories could then expand to compensate, if the underlying software implements a sort of "conserving energy" rule. A reduction in weighting of one category would result in a different filter setting to be applied to the data set. In other words, the system presents only a subset of program entries which conform to the filtering setting defined by the position of the soft keys. As a result, the user will be able to feel and remember a particular filter setting through the force feedback provided by the device.

According to the present invention, the ability to transfer aspects of a device (such as the user interface) to another device does not necessarily require a data connection between these devices. For instance, the user interface of an air-conditioning system can be transferred to a TV, but sending other data would not make sense. On the other hand, video recorder and TV do indeed share their data to the advantage of both devices.

Therefore, the virtual control network can be part of another network such as a network created via i.LINK, or it can be spanned between devices using bi-directional IR links. In order to be able to select a specific device, several technologies are available as described above.

Further, it is obvious that the present invention is not limited to the specific embodiment described above, but all preferred features incorporated into the remote control according to the present invention might advantageously be combined in every rational manner.

## Claims

1. Remote control, comprising a transmission means to transmit a command to a controllable device, **characterized by**
a selection means for selecting a controllable device comprising
- means for pointing the remote control to said controllable device as an initializing communication step, and
- means for indicating to the remote control that said device to which the remote control is pointed is to be selected,
a receiving means for receiving a user interface of a controllable device upon selection of said controllable device with said selection means of the remote control, and
an adaptation means controlling an adaptation of said remote control to the user interface received upon said selection.

2. Remote control according to claim 1, further comprising a camera and an image processing unit to identify a controllable device to which the remote control is pointed.

3. Remote control according to claim 1 or 2, further comprising an infrared spot meter for identifying a device to which the remote control is pointed on basis of an infrared code transmitted by said controllable device.

4. Remote control according to claim 1,2 or 3, further comprising a scanner unit for identifying a device to which the remote control is pointed on basis of a bar-code attached to said device.

5. Remote control according to anyone of the preceding claims, further comprising
a mechanical interface unit,
a speech interface unit
a gesture interface unit and/or
a graphics interface unit
as a user interface for the remote control for manipulating the received user interface of said selected controllable device, thereby generating a command to be transmitted to said selected controllable device.

6. Remote control according to claim 5, **characterized in that** said mechanical interface unit comprises at least one soft key and/or rotary dial.

7. Remote control according to claim 6, **characterized in that** said at least one soft key and/or rotary dial is/are haptically enhanced.

8. Remote control according to anyone of claims 5 to 7, **characterized by** a tilt sensor according to which output signal the manipulation of the received user interface is biased towards one of at least two interface units of the remote control and/or an appearance of an interface unit of the remote control is controlled.

9. Remote control according to anyone of the preceding claims, **characterized in that** said adaptation of the remote control is a projection of the received user interface onto a screen of the remote control and a fixed or variable assignment of projected controls to a user interface of the remote control.

## Patentansprüche

1. Fernbedienungseinrichtung mit einer Übertragungseinrichtung zum Übertragen eines Kommandos an ein steuerbares Gerät, **gekennzeichnet durch**
eine Auswahleinrichtung zum Auswählen eines steuerbaren Geräts mit
- einer Einrichtung zum Zeigen der Fernbedienungseinrichtung auf das steuerbare Gerät als initialisierenden Kommunikationsschritt und
- einer Einrichtung zum Anzeigen an die Fernbedienungseinrichtung, dass das Gerät, auf welche die Fernbedienungseinrichtung zeigt, auszuwählen ist,
eine Empfangseinrichtung zum Empfangen einer Benutzerschnittstelle eines steuerbaren Geräts auf eine Auswahl des steuerbaren Geräts mittels der Auswahleinrichtung der Fernbedienungseinrichtung hin und
eine Anpassungseinrichtung, welche eine Anpassung der Fernbedienungseinrichtung an die Benutzerschnittstelle, die in Antwort auf die Auswahl erhalten wurde, steuert.

2. Fernbedienungseinrichtung nach Anspruch 1, welche des Weiteren eine Kamera und eine Bildverarbeitungseinheit aufweist zum Identifizieren eines steuerbaren Geräts, auf welches die Fernbedienungseinrichtung zeigt.

3. Fernbedienungseinrichtung nach einem der Ansprüche 1 oder 2, welche des Weiteren ein Infrarotmessgerät aufweist zum Identifizieren eines Geräts, auf welches die Fernbedienungseinrichtung zeigt, und zwar auf der Grundlage eines vom steuerbaren Gerät übertragenen Infrarotcodes.

4. Fernbedienungseinrichtung nach einem der Ansprüche 1, 2 oder 3, welche des Weiteren eine Scannereinheit aufweist zum Identifizieren eines Geräts, auf welches die Fernbedienungseinrichtung zeigt, und zwar auf der Grundlage eines am Gerät angebrachten Barcodes.

5. Fernbedienungseinrichtung nach einem der vorangehenden Ansprüche, welche des Weiteren aufweist:
eine mechanische Schnittstelleneinheit,
eine Sprachschnittstelleneinheit,
eine Gestenschnittstelleneinheit und/oder
eine graphische Schnittstelleneinheit,
nämlich als Benutzerschnittstelle für die Fernbedienungseinrichtung zum Manipulieren der empfangenen Benutzerschnittstelle des ausgewählten steuerbaren Geräts, um dadurch ein Kommando zu erzeugen, welches an das ausgewählte steuerbare Gerät zu übertragen ist.

6. Fernbedienungseinrichtung nach Anspruch 5, **dadurch gekennzeichnet, dass** die mechanische Schnittstelleneinheit eine Taste und/oder eine rotierbare Wählscheibe aufweist.

7. Fernbedienungseinrichtung nach Anspruch 6, **dadurch gekennzeichnet, dass** die Taste und/oder die drehbare Wählscheibe haptisch erweitert ausgebildet ist/sind.

8. Fernbedienungseinrichtung nach einem der vorangehenden Ansprüche 5 bis 7, **gekennzeichnet durch** einen Neigungssensor, gemäß dessen Ausgabesignal die Manipulation der empfangenen Benutzerschnittstelle in Richtung auf eine von mindestens zwei Schnittstelleneinheiten der Fernbedienungseinrichtung voreingestellt und/oder eine Erscheinung einer Schnittstelleneinheit der Fernbedienungseinrichtung gesteuert wird.

9. Fernbedienungseinrichtung nach einem der vorangehenden Ansprüche, **dadurch gekennzeichnet, dass** die Anpassung der Fernbedienungseinrichtung eine Projektion der empfangenen Benutzeroberfläche auf einem Anzeigeschirm der Fernbedienungseinrichtung und eine feste oder variable Zuordnung projizierter Steuerelemente in Bezug auf eine Benutzerschnittstelle der Fernbedienungseinrichtung darstellt.

## Revendications

1. Télécommande, comprenant des moyens d'émission pour émettre une commande vers un dispositif pouvant être commandé,
**caractérisée par**
des moyens de sélection pour sélectionner un dispositif pouvant être commandé comprenant :
- des moyens pour pointer la télécommande vers ledit dispositif pouvant être commandé en tant qu'étape d'initialisation de communication, et
- des moyens pour indiquer à la télécommande que ledit dispositif vers lequel la télécommande est pointée doit être sélectionné,
des moyens de réception pour recevoir une interface utilisateur d'un dispositif pouvant être commandé lors de la sélection dudit dispositif pouvant être commandé par lesdits moyens de sélection de la télécommande, et
des moyens d'adaptation commandant une adaptation de ladite télécommande à l'interface utilisateur reçue lors de ladite sélection.

2. Télécommande selon la revendication 1, comprenant en outre une caméra et une unité de traitement d'image pour identifier un dispositif pouvant être commandé vers lequel la télécommande est pointée.

3. Télécommande selon la revendication 1 ou 2, comprenant en outre un dispositif de mesure de point infrarouge pour identifier un dispositif vers lequel la télécommande est pointée sur la base d'un code infrarouge transmis par ledit dispositif pouvant être commandé.

4. Télécommande selon la revendication 1, 2 ou 3, comprenant en outre une unité de balayage pour identifier un dispositif vers lequel la télécommande est pointée sur la base d'un code à barres fixé sur ledit dispositif.

5. Télécommande selon l'une quelconque des revendications précédentes, comprenant en outre :
une unité d'interface mécanique,
une unité d'interface vocale,
une unité d'interface gestuelle, et / ou
une unité d'interface graphique
en tant qu'interface utilisateur pour la télécommande pour manipuler l'interface utilisateur reçue dudit dispositif pouvant être commandé sélectionné, générant de ce fait une commande à transmettre audit dispositif pouvant être commandé sélectionné.

6. Télécommande selon la revendication 5, **caractérisée en ce que** ladite unité d'interface mécanique comprend au moins une touche programmable et / ou un cadran rotatif.

7. Télécommande selon la revendication 6, **caractérisée en ce que** ladite au moins une touche programmable et / ou ledit au moins un cadran rotatif sont améliorés haptiquement.

8. Télécommande selon l'une quelconque des revendications 5 à 7, **caractérisée par** un capteur d'inclinaison selon le signal de sortie duquel la manipulation de l'interface utilisateur reçue est appliquée à l'une d'au moins deux unités d'interface de la télécommande et / ou un aspect d'une unité d'interface de la télécommande est commandé.

9. Télécommande selon l'une quelconque des revendications précédentes, 1 **caractérisée en ce que** ladite adaptation de la télécommande est une projection de l'interface utilisateur reçue sur un écran de la télécommande et une attribution fixe ou variable des commandes projetées à une interface utilisateur de la télécommande.
